# EUROPEAN PATENT APPLICATION

(11) **EP 2 546 756 A2**
(43) Date of publication of application: **16.01.2013**
(21) Application number: 12176434.4
(22) Date of filing: 13.07.2012
(51) Int. Cl.: G06F 13/16

(54) **Effective utilization of flash interface**

(30) Priority: 14.07.2011 US 201161507654 P; 05.01.2012 US 201213344030
(71) Applicant: LSI Corporation, Milpitas, CA 95035 (US)
(72) Inventor: Somanache, Vinay Ashok, 411027, Pune-Maharashtra (IN); Swatosh, Timothy W., Rochester, MN 55960 (US); Hempstead, Pamela S., Oronoco, MN 55960 (US); Ellis, Jackson L., Fort Collins, CO 80528 (US); Hicken, Michael S., Rochester, MN 55902 (US); Dell, Martin S., Betlehem, PA 18020 (US)
(74) Representative: Williams, David John

(57) **Abstract**

An apparatus including a first circuit, a second circuit, and a third circuit. The first circuit may be configured to maintain die-based information used for operation of a flash lane controller (FLC). The second circuit may be configured to manage contexts that are actively being processed by the flash lane controller (FLC). The third circuit may be configured to perform pipeline execution of a plurality of the contexts managed by the second circuit.

## Description

This application claims the benefit of U.S. Provisional Application No. 61/507,654, filed July 14, 2011 and is hereby incorporated by reference in its entirety.

This application is related to co-pending U.S. Application No. 13/332,849, filed December 21, 2011, and U.S. Application No. 13/344,599, filed December 22, 2011, which are hereby incorporated by reference in their entirety.

### Field of the Invention

The present invention relates to flash memory systems generally and, more particularly, to a method for effective utilization of a flash interface.

### Background of the Invention

A flash media controller communicates to flash devices via a flash interface such as ONFI 2.X. On a single flash interface, a fixed number of flash targets can be connected. The connection of multiple flash targets on a single flash interface results in the flash interface being shared between the multiple flash targets. Sharing the flash interface being between multiple flash targets can produce a bottleneck with the flash devices.

It would be desirable to have a method for effective utilization of a flash interface.

### Summary of the Invention

The present invention concerns an apparatus including a first circuit, a second circuit, and a third circuit. The first circuit may be configured to maintain die-based information used for operation of a flash lane controller (FLC). The second circuit may be configured to manage contexts that are actively being processed by the flash lane controller (FLC). The third circuit may be configured to perform pipeline execution of a plurality of the contexts managed by the second circuit.

The objects, features and advantages of the present invention include providing a method for effective utilization of a flash interface that may (i) manage per-die information in a die management table, (ii) arbitrate among multiple dies for access to be queued to a context table, (iii) update die state using a die state machine, (iv) perform/monitor multi-die operation, (v) stage and execute phases of operation on a flash lane controller, (vi) maintain priority ordering of all active contexts on the flash lane, (vii) maintain the state of each context on the flash lane, (viii) provide the minimum amount, or minimize the amount of temporary on-chip storage of contexts used to execute full transactions, (ix) maintain the buffer pointer of each context that is in the process of being executed, (x) provide agency for each context by determining the next state of the context using a context state machine, (xi) maintain minimal context information in a priority queue of contexts currently being executed, (xii) remove completed contexts from the priority queue and compress the queue to eliminate gaps.

### Brief Description of the Drawings

These and other objects, features and advantages of the present invention will be apparent from the following detailed description and the appended claims and drawings in which:
FIG. 1 is a block diagram illustrating a flash media controller implemented in a system on a chip (SOC) context;
FIG. 2 is a block diagram illustrating an example flash media controller (FMC) architecture in accordance with an embodiment of the present invention;
FIG. 3 is block diagram illustrating an example flash lane controller architecture in accordance with an embodiment of the present invention;
FIG. 4 is a diagram illustrating example submodules of the context manager module of FIG. 3;
FIG. 5 is a diagram illustrating example submodules of the die management module of FIG. 3;
FIG. 6 is a diagram illustrating example submodules of the flash operation manager module of FIG. 3;
FIG. 7 is a diagram illustrating example submodules of the dataflow manager module of FIG. 3;
FIG. 8 is a diagram illustrating an example implementation of the context manager module of FIG. 3;
FIG. 9 is a flow diagram illustrating pipeline execution of entries in a context table FIG. 8;
FIG. 10 is a diagram illustrating an example implementation of the context state machine of FIG. 8;
FIG. 11 is a timing diagram illustrating an example read timing on the flash operation manager (FOM) context table access interface of FIG. 8; and
FIG. 12 is a diagram illustrating an example implementation of the die management module of FIG. 3.

### Detailed Description of the Preferred Embodiments

In one embodiment, a system in accordance with the present invention may be designed to operate with various mass storage protocols, including SAS ("Serial Attached SCSI"), FC ("Fibre Channel") and FC-AL ("Fibre Channel Arbitrated Loop), all of which are based on the Small Computer Systems Interface ("SCSI"), and Serial ATA ("SATA") protocols. A person of ordinary skill in the art would be familiar with the mass storage protocols and, therefore, such protocols will not be further described herein. Except where particular protocols are called out, the systems and methods disclosed herein do not depend on the particular protocol being used and are designed to operate correctly with all of the protocols. Moreover, the systems and methods in accordance with embodiments of the present invention may be adapted for use with other similar protocols, either currently in use or yet to be developed, including protocols for enterprise-level applications as well as protocols for other applications, such as end-user. The system described herein includes a novel method for effective utilization of a flash interface.

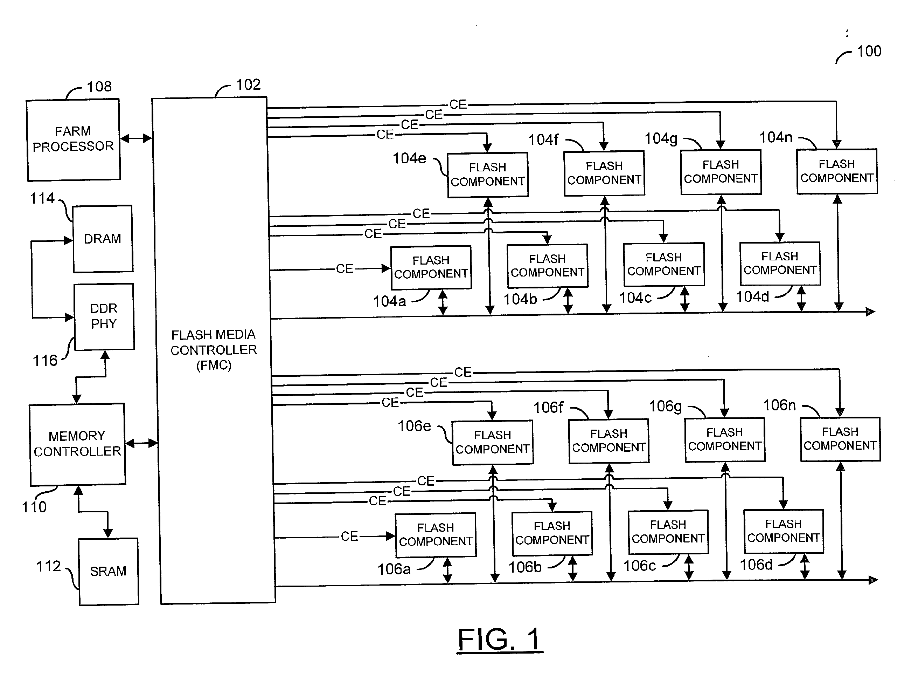

Referring to FIG. 1, a block diagram of a system 100 is shown implemented with a flash media controller in accordance with an embodiment of the present invention. In one example, the system (or architecture) 100 may comprise a block (or circuit) 102, a number of blocks (or circuits) 104a-104n, a number of blocks (or circuit) 106a-106n, a block (or circuit) 108, a block (or circuit) 110, a block (or circuit) 112, a block (or circuit) 114, and a block (or circuit) 116. The circuits 102 through 116 may represent modules and/or blocks that may be implemented as hardware, firmware, software, a combination of hardware, firmware and/or software, or other implementations.

In one example, the block 102 may implement a flash media controller (FMC) in accordance with an embodiment of the present invention. The blocks 104a-104n may be implemented as a first number of flash storage devices or components. The blocks 104a-104n may be coupled to a first flash lane of the block 102. The first flash lane of the block 102 may be configured to provide independent chip enable (CE) signals to each of the blocks 104a-104n. The blocks 106a-106n may be implemented as a second number of flash storage devices or components. The blocks 106a-106n may be coupled to a second flash lane of the block 102. The second flash lane of the block 102 may be configured to provide independent chip enable (CE) signals to each of the blocks 106a-106n. Although the FMC 102 is illustrated with two flash lane instances, it will be apparent to those skilled in the art that additional flash lanes may be implemented accordingly to meet the design criteria of a particular implementation. The flash components 104a-104n and 106a-106n may be implemented as a single flash package comprising one or more dies. The flash components 104a-104n and 106a-106n may be implemented using NAND and/or NOR flash devices. The block 102 may include the appropriate physical layer support (PHY) for NAND flash and/or NOR flash.

The block 108 may implement an external FMC processor (FARM) that may be coupled to the block 102. The block 110 may implement a memory controller that may be configured to couple static random access memory (SRAM) and/or dynamic random access memory (DRAM) to the block 102. The block 112 may be implemented as one or more SRAM devices. The block 114 may be implemented as one or more DRAM devices. The block 116 may implement a double data rate physical layer (PHY) interface coupling the block 110 and the block 114. In one example, the blocks 102, 108, 110, 112, 114, and 116 may implement a system on chip (SOC) architecture.

The block 102 may be implemented as a soft IP block configured to assist various applications to use the flash devices 104a-104n and 106a-106n. As used herein, the term soft IP block generally refers to a building block of an integrated circuit that may be provided in software (e.g., HDL Code, RTL code, etc.). The block 102 generally supports multiple flash interfaces with flash devices. The block 102 does not generally include a processor (e.g., ARM). However the block 102 may implement, in one example, an interface (e.g., 32-bit AHB, etc.) configured to couple the block 102 to the external processor 108. The block 102 is generally configured to handle management of a flash media mass storage array formed by the blocks 104a-104n and 106a-106n. In one example, the block 102 may exploit a multiply-instantiated flash lane controller (FLC), which may perform most of the management functions associated with a single flash data lane with multiple independent flash components attached. The function of the block 102 may be somewhat generic in a sense that the block 102 may understand little about flash access. The block 102 is generally more concerned with weaving the flash-aware lanes into a single hardware entity. In one example, the soft IP implementing the block 102 may be parameterized to support the maximum possible lanes for an application. For example, in one implementation the number of lanes may be two. In another implementation the number may be eight.

In one example, the block 102 may support features including: (i) two flash lanes; (ii) up to eight chip enable signals (CEs) on each flash lane; (iii) flash interfaces including asynchronous normal mode, asynchronous extended mode, Toggle 1.0, ONFI 2.1, ONFI 2.3, and Toggle 2.0; (iv) dedicated ECC or shared ECC between multiple lanes that may be hardware configurable (e.g., a parameterized feature of a soft IP block implementing the block 102); (v) 8-bit data on the flash interface; (vi) up to 200 MHz DDR rate on the flash interface in the Toggle 2.0 or ONFI 2.3 flash interface specification; (vii) partial read command, (viii) random read command; (ix) CRC Strip/Insert option on flash Write/Read; (x) up to 64-bit correction for 4K bytes of data; (xi) configurable n-bit correction (max n = 64) on 512, 2K, 4K bytes of data; (xii) a 32-bit AHB interface for register programming; (xiii) storage of contexts commands on external memory (e.g., DRAM or SRAM); (xiv) cut-through buffers in flash lane controllers; (xv) independent flash read and write data path to provide better performance; (xvi) in-order status reported per flash unit number (FUN); (xvii) support for one read and one write buffer controller (BC) interface for data path per flash lane; (xviii) support for read BC interface for context retrieval; (xix) support for write BC interface for context update; (xx) support for read/write BC interface for context free resource pointers (CFRP).

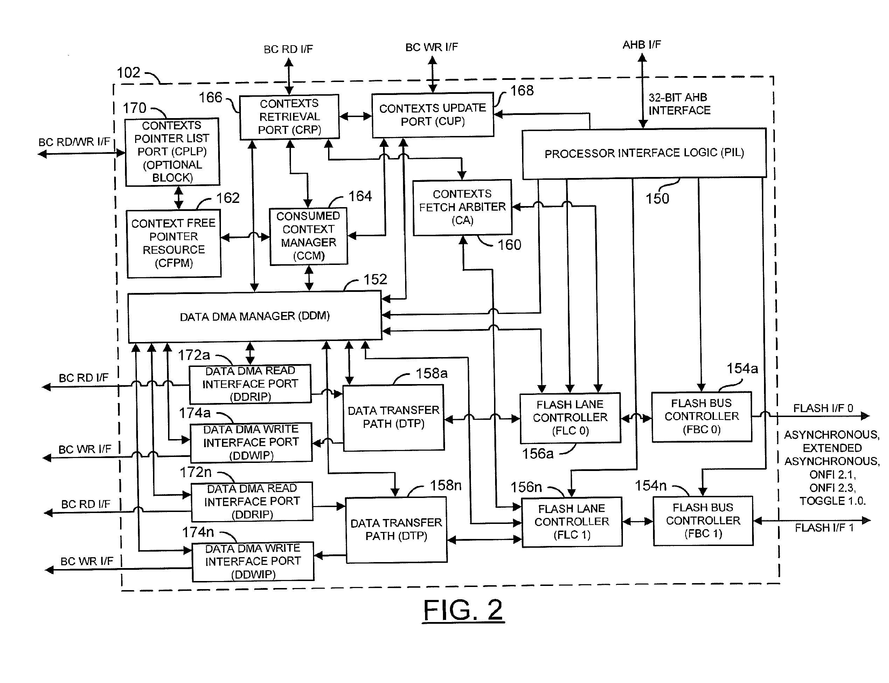

Referring to FIG. 2, a more detailed block diagram of the block 102 of FIG. 1 is shown illustrating an example flash media controller (FMC) architecture in accordance with an embodiment of the present invention. In one example, the block 102 may implement three major functional interfaces, a buffer controller (BC) interface, a flash device interface, and a processor interface (e.g., 32-bit AHB, etc.). The buffer controller (BC) interface is illustrated on the left side and top-left of the block diagram. In one example, seven buffer controller interfaces (e.g., three read interfaces BC_RD_I/F, three write interfaces BC_WR_I/F, and one read/write interface BC_RD/WR_I/F) may be implemented. The flash device interface is illustrated on the right side of the block diagram. In one example, two flash lane interfaces (e.g., FLASH_I/F_0 and FLASH_I/F_1) may be implemented. The 32-bit AHB interface is illustrated on the top-right of the block diagram. The 32-bit AHB interface may be used, in one example, to program registers, read status and use diagnostic registers within the block 102.

The block 102 generally comprises a block (or circuit) 150, a block (or circuit) 152, a number of blocks (or circuits) 154a-154n, a number of blocks (or circuit) 156a-156n, a number of blocks (or circuit) 158a-158n, a block (or circuit) 160, a block (or circuit) 162, a block (or circuit) 164, a block (or circuit) 166, a block (or circuit) 168, a block (or circuit) 170, a number of blocks (or circuit) 172a-172n, and a number of blocks (or circuit) 174a-174n. The circuits 150 through 174a-174n may represent modules and/or blocks that may be implemented as hardware, firmware, software, a combination of hardware, firmware and/or software, or other implementations. The block 150 may implement a processor interface logic (PIL). The block 152 may implement a data DMA manager (DDM). The blocks 154a-154n may implement flash bus controllers (FBCs). The blocks 156a-156n may implement flash lane controllers (FLCs). The blocks 158a-158n may implement data transfer paths (DTPs). The block 160 may implement a contexts fetch arbiter (CA). The block 162 may implement a context free pointer resource (CFPM). The block 164 may implement a consumed context manager (CCM). The block 166 may implement a contexts retrieval port (CRP). The block 168 may implement a contexts update port (CUP). The block 170 may implement a contexts pointer list port (CPLP). The block 170 is generally optional. The blocks 172a-172n may implement data DMA read interface ports (DDRIPs). The blocks 174a-174n may implement data DMA write interface ports (DDWIPs). Together, the blocks 172a-172n and 174a-174n generally form a data DMA interface port (DDIP).

In one example, the block 150 may provide an interface from the block 108 to addressable resources of the block 102 (e.g., via an AMBA AHB-Lite interface). The block 150 may provide the interface to all addressable resources and direct interface to configuration and status registers of submodules in the block 102 that do not reside within the blocks 156a-156n. The block 150 may also provide an interface to the addressable resources that reside within the individual blocks 156a-156n. In addition, the block 150 may contain a context construction buffer (CCB), where processor firmware may write the actual media context into the block 102 for storage into the system buffer via the block 168. In one example, the block 150 may include the following features: a 32-bit AMBA AHB-Lite slave interface to the block 108, a system clock (e.g., SYS_CLK) that may be some divided value of (or the same as) an incoming clock (e.g., HCLK), access to all configuration and status registers as well as all processor-addressable space in the block 102, the context construction buffer (CCB) used by processor firmware to build contexts that are stored in the system buffer, a processor interface that is distributed to each of the blocks 156a-156n, where access of addressable resources is handled by processor access ports (PAP), and contains registers that may be used by multiple submodules in the block 102. The block 150 may perform all register decoding and all read data multiplexing for all addressable resources not stored logically in the blocks 156a-156n.

The block 152 generally manages two data transfers, one for flash program (e.g., data transaction from a buffer to a flash device) and another for flash read (e.g., data transaction from flash device to a buffer). The DMA data path generally comprises separate 32-bit read and write data busses from the blocks 156a-156n through respective blocks 158a-158n, and the data DMA interface port (DDIP) blocks 172a-172n and 174a-174n. The blocks 158a-158n may contain the ECC function. A DMA data transfer generally comprises a sequence of events that may include multiple accesses to the corresponding context by other sub-blocks (or port blocks) of the block 102. In one example, a DMA transfer may include a FLC request, a retrieve context operation, a data transfer, and a FLC done phase.

In the FLC request step, data transfer may begin with one of the blocks 156a-156n raising a respective request line. In the retrieve context operation, corresponding context may be retrieved from a buffer controller via the context retrieval port (CRP) interface 166. The data transfer may occur among the DDIP, DTP, and FLC blocks, during which the context may be sent to the DDIP and may or may not be written back. In the FLC done phase, a done line to the selected block 156a-156n may be raised to indicate the end of the transfer. The DDM 152 may act to retrieve the context and provide the inputs to the DTP block to facilitate the data transaction.

The blocks 154a-154n generally perform the low-level interface signaling to a set of NAND flash devices on a respective flash lane. There is generally one flash bus controller (FBC) 154a-154n for each flash lane controller (FLC) 156a-156n. The blocks 154a-154n generally manage the timing of each cycle of flash interface protocol for several interface types as well as different timing modes for a given type (e.g., Asynchronous, ONFI 2.0 Synchronous, ONFI 2.3 Synchronous, Samsung Toggle 1.0, Samsung Toggle 2.0, etc). Cycle timing may be controlled, in one example, via timing counts stored in a group of internal timing registers. The core logic of the blocks 154a-154n generally operates in a different clock domain than the rest of the block 102. In general, only the timing register sets reside in the same clock domain as the rest of the blocks 156a-156n. No synchronization logic is generally needed between these registers and the FBC core because the registers are treated as static since the registers are written only when the FBC is quiescent (e.g., no outstanding operations).

The blocks 156a-156n generally perform scheduling of the commands to each die. The blocks 156a-156n manage the sequencing of the commands on each respective flash lane. The blocks 156a-156n provide control and status registers through which firmware may program the die and observe the status. Each of the blocks 156a-156n include context management and die management. The blocks 156a-156n are generally responsible for the processing of the contexts.

Each of the blocks 158a-158n routes data traffic and enables flow control of each interface for data flow in between one of the blocks 154a-154n, an optional internal ECC encoder/decoder, and the respective data DMA interface port (DDIP). In one example, the internal ECC encoder/decoder may be implemented within the blocks 158a-158n. Alternatively, each of the blocks 158a-158n may be configured to share a single ECC encoder/decoder module. The blocks 158a-158n may be programmed for each transfer by both the respective data DMA manager (DDM) module 152 and respective data DMA interface port (DDIP) blocks 172a-172n and 174a-174n. Each block 158a-158n may include independent flash read and write paths, which may operate in a full duplex mode of operation. The blocks 158a-158n maintain current region counts during a data transfer as well as current dword counts within each region. The blocks 158a-158n generally perform flow control translation between the DDIP, ECC encoder & decoder, and FLC blocks. The blocks 158a-158n maintain a running correctable ECC error sum for each transfer and present a final value to the block 152 at the end of a transfer. The blocks 158a-158n may contain the FMC registers used for programming the ECC encoder & decoder. Registers may be accessed via a register interface from the block 150. The ECC module is generally capable of 64-bit correction over 4K bytes of data. However, other levels of correction may be implemented accordingly to meet the design criterial of a particular implementation. In one example, a decoder gate count may be 415K gates and an encoder gate count may be 75K gates.

The block 160 is generally responsible for accepting requests for contexts from the blocks 156a-156n, retrieving the requested contexts from the system buffer (e.g., the DRAM accessed through the buffer controller), then delivering the contexts to the blocks 156a-156n. The retrieval may actually be performed via request to the context retrieval access port (CRP) 166. Contexts are the basic unit of control in the FMC. Contexts generally contain all the information needed by an FLC to execute a command and by the FMC to perform the associated data transfer (DMA) to or from the system buffer. The FLCs act completely autonomously; thus, the FLCs require arbitration for access via the buffer controller to the system buffer, which contains the linked lists of contexts built by the firmware. The block 160 generally provides the arbitration, as well as initiating the request to the block 166. The block 160 then routes the retrieved contexts transparently to the respective FLC destinations. The block 162 is generally implemented as a sub-block of the block 102 to provide a single point where the free pointers are available to firmware.

The block 164 is generally implemented as a sub-block of the block 102 to provide a single point where completed contexts may be inspected by firmware after completion. The block 164 generally performs arbitration among multiple FLC sources. The FLCs provide PASS/FAIL ECC status associated with the context pointer. The block 164 updates the context status field once the context is fetched, then presents the context to the firmware. In the case where the firmware takes a longer time to read the completed contexts and the internal memory within the block 164 is about to become full, the block 164 may use a buffer to store the completed contexts that are enqueued after the current reported context.

The blocks 166-174n generally implement a port interface. The port interface may be used to communicate with the buffer controller. In one example, a QBFIFO block may be implemented within the port interface. The following port interfaces may be implemented also as part of the port interface: contexts retrieval port (CRP) 166, contexts update port (CUP) 168, contexts pointer list interface port (CPLIP) 170 (optional), data DMA read interface port (DDRIP) 172a-172n, and data DMA write interface port (DDWIP) 174a-174n. In one example, the interface signals of the block 102 may be grouped into four major interfaces: a AHB interface, a buffer controller interface, a NAND and/or NOR flash physical layer (PHY) interface, and a miscellaneous (MISC) interface. The buffer controller interface may comprise (i) DDIP BC write interfaces for lane 0 & lane 1, (ii) DDIP BC read interfaces for lane 0 & lane 1, (iii) a CRP BC read interface, (iv) a CUP BC write Interface, and (v) a CPLIP BC read/write interface.

In one example, the block 102 may be implemented with three clocks. The majority of the logic in the block 102 may operate on a clock domain called system clock (e.g., SYS_CLK). The system clock may be the AHB clock. The system clock generally has a frequency that may be one-half of the operating frequency of the FMC Processor (FARM) 112. The second clock may be called the flash clock (e.g., FBC_CLK). The flash bus controllers (FBCs) 154a-154n may operate completely on the flash clock domain. In one example, first-in first-out buffers (FIFOs) may be implemented in a Dataflow Manager(DM) module of the blocks 154a-154n to manage the frequencies between the clocks FBG_GLK and SYS_GLK. The third clock may be the buffer controller clock (e.g., BC_CLK). All interface ports with the BC are operating on the buffer controller clock domain. A buffering element (e.g., QBFIFO) may be implemented between the buffer controller clock BC_CLK and the system clock SYS_CLK.

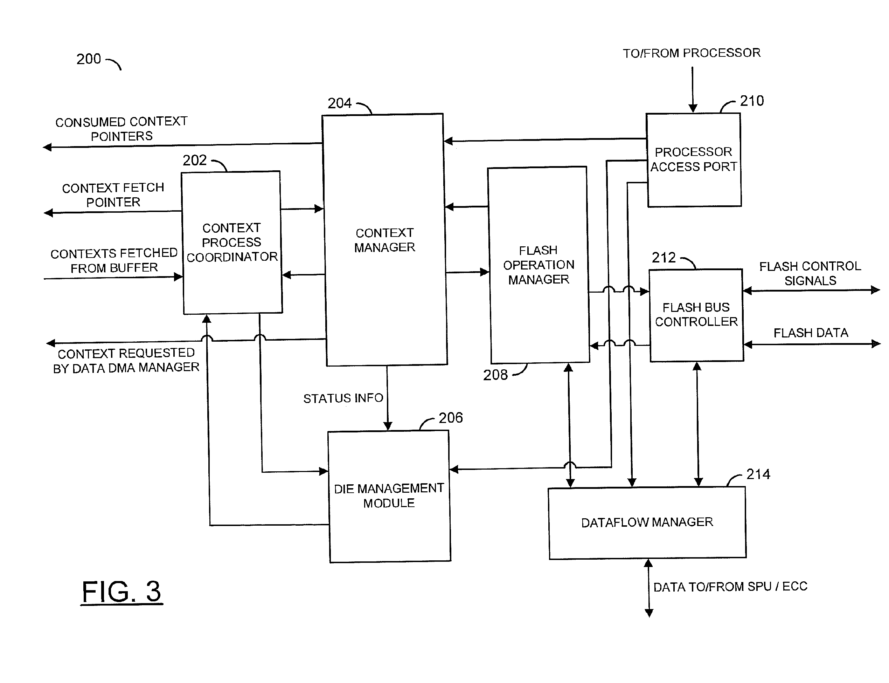

Referring to FIG. 3, a diagram of a block 200 is shown illustrating an example flash lane controller architecture in accordance with an embodiment of the present invention. The block 200 may be used, in one example, to implement the blocks 154a-154n and 156a-156n in FIG. 2. In one example, the block (or circuit) 200 may comprise a block (or circuit) 202, a block (or circuit) 204, a block (or circuit) 206, a block (or circuit) 208, a block (or circuit) 210, a block (or circuit) 212, and a block (or circuit) 214. The circuits 202 to 210 may represent modules and/or blocks that may be implemented as hardware, firmware, software, a combination of hardware, firmware and/or software, or other implementations. The block 202 may implement, in one example, a context process coordinator (CPC). The block 204 may implement, in one example, a context manager (CM). The block 206 may implement, in one example, a die management module (DMM). The block 208 may implement, in one example, a flash operation manager (FOM). The block 210 may implement, in one example, a processor access port (PAP). The block 212 may implement, in one example, a flash bus controller (FBC). The block 214 may implement, in one example, a data flow manager (DFM).

The block 202 may assist in the flow of context information into and out of the block 200. Context flow may be initiated by the block 204. The block 202 is primarily concerned with responding to the requests to acquire or dispose of contexts. To acquire contexts, the block 202 responds to the request for a new context by the block 204. First, the block 202 may initiate a request to the block 206, which arbitrates among the die managed by the block 200 and forwards the context for the selected die or logical unit number (LUN) to the block 202. The block 202 then issues a fetch to the context fetch arbiter (CFA) (e.g., block 160 in FIG. 2), which attempts to retrieve the context from the system buffer.

Once fetched, the context is delivered to the block 202. The block 202 performs some interpretation on the context and forwards the context to the block 204. If the block 206 does not have a die (LUN) available to initiate a context execution, the block 206 informs the block 202 of the lack of an available die, and the block 202 communicates the lack of an available die back to the block 204. The block 202 also assists the block 200 in the disposal of completed contexts. Again, it is the block 204 that initiates this flow, and the block 202 that issues the disposal message to the block implementing the consumed context manager (CCM) (e.g., block 164 in FIG. 2). When the disposal message has been received and acted upon by the CCM, the block 202 informs the block 204, which may then continue context process execution.

The block 202 generally performs some interpretation of the contexts. Specifically, the block 202 may interpret contexts for the purpose of determining whether a context is a Processor Control Mode (PCM) context. When a PCM context is received, context fetching (appending) should cease. The block 202 then waits for the block 204 to begin executing the PCM context and resumes "standard" operation when the processor control mode is completed. During the processor control mode interval, the block 202 determines whether fetched contexts are full 15 dword contexts instead of 4 dword flash contexts, which the block 202 sends to the block 204 in "standard" operation.

The block 204 may, in one example, comprise a context state machine (CSM), a context fetch manager (CFM), a context disposal engine (CDE), and a context interpreter (CI). The block 204 is generally responsible for managing the contexts that are actively being processed by the block 200. The block 204 generally performs the "bookkeeping" of active contexts. Contexts are data structures that provide all the information needed by the flash media controller (FMC) to execute flash transactions and DMAs to the system buffer. The block 204 manages the contexts at the level of the flash lane controller and thus is primarily concerned with the context management as it relates to the flash transaction. The block 204 maintains the information used by the block 208 to perform commands and data transfers to the flash dies on the flash lane.

The block 206 is generally responsible for maintaining die-based information needed for operation of the block 200. The block 206 manages per-die information in the die management table and arbitrates among the dies for access to be queued to the context table. The block 206 may include, in one example, a die state machine to update a die state. The block 206 may perform/monitor multi-die operations. The block 206 is generally responsible for flash commands including, but not limited to READ, COPYBACK READ/COPYBACK WRITE, BLOCK ERASE, PAGE PROGRAM, and Target level commands including, but not limited to READ ID, READ PARAMETER PAGE, GET FEATURES, SET FEATURES, SYNCHRONOUS RESET, and RESET.

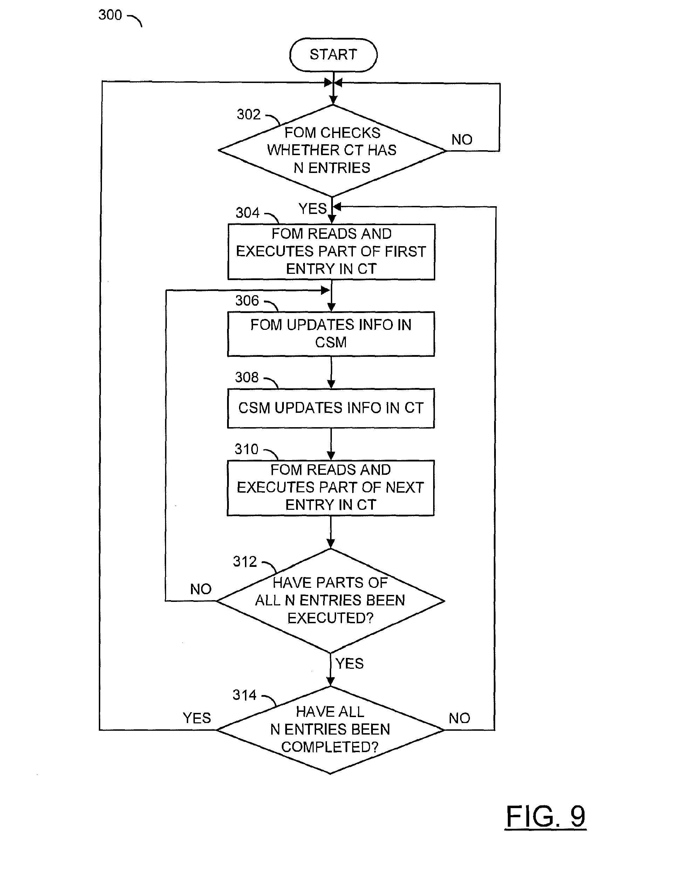

The block 208 generally handles the sequencing of each flash operation applied to the flash lane. One block 208 is generally implemented for each flash lane controller (FLC) of the flash media controller. The block 208 arbitrates between the commands in the context table in the block 204, and applies the commands to the block 212. In one example, the block 208 natively supports the most common commands from the ONFI 2.0 command list, as well as some specific (and similar) commands found in the Samsung NAND flash devices. In addition, other existing and future commands may be supported via a nano-sequencer (described in more detail below in connection with FIGS. 9-11). Natively supported commands are run without processor intervention, but other commands generally use some level of processor support.

The flash commands may be broken down into atomic "cycles" that may be applied serially to the actual flash dies controlled by the block 208. Because the flash commands typically involve long wait times (e.g., a page read may take 25µs before the data are available to be read from the chip), the "command cycles" may often be run "back to back" to different die on the flash lane, thus cutting down the effective, cumulative wait times. The block 208 generally manages the flash die by updating the status of the die as each flash "cycle" is applied. The block 208 then reads the updated context table to decide what "cycle" should be (or can be) executed next. A NAND flash operation generally consists of one or more flash cycles. There are generally four types of flash cycles: Command, Address, Data Output (w.r.t. flash device - e.g., a read), and Data Input (w.r.t. flash device - e.g., a write). The cycle types roughly translate to the operation types defined between the block 208 and the block 212.

The block 210 generally implements an interface block that provides processor access from the AHB-Lite slave interface of the FMC 100 to the addressable resources inside the block 200. Most of the resources addressed here are accessible primarily for diagnostic purposes, as all configuration signals are presented at the global level (as part of a shared configuration registers block). For example, full access to the flash lane data buffers may be available through the block 210. The access may be provided purely as an early verification scaffold. However, access to the flash lane data buffers may also support firmware patches that need direct access to internal tables. Such accesses may be provided through the block 210.

Features of the block 210 may include: a simple access interface that follows the AHB-Lite slave protocol and is buffered by the Processor Interface Logic (PIL) in the FMC; read and write access provided to register resources, context table, context cache, and die management table; read and write access provided to the flash lane data buffer memory resource, located in the block 214. The block 210 generally supports an ability to add per-lane configuration registers, though most configuration registers are generally provided as inputs to the block 200. Similarly, status and interrupt register access may be supported, though most status and interrupt registers are generally generated outside the block 200. The primary logic groups of the block 210 may include: Interface Manager (IF_MGR), Dataflow Manager Interface (DM_IF), Register Block Decoder (REG_DEC), Register Block Multiplexer (REG_MUX), Interrupt Handler (INT_HND), and FLC Global Registers (GLOB_REGS).

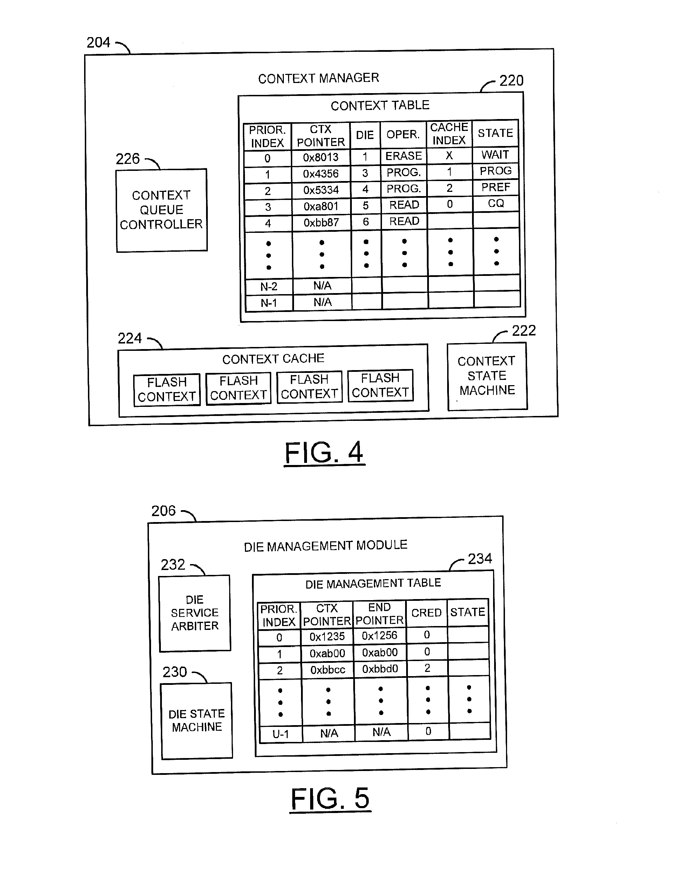

Referring to FIG. 4, a diagram is shown illustrating submodules of the context manager module 204 of FIG. 3. In one example, the block 204 may include a context table (CT) 220, a context state machine (CSM) 222, a context cache (CC) 224, and a context queue controller (CQC) 226. The block 204 generally stages and executes phases of operation on the flash lane controller, maintains the priority ordering of all active contexts on the flash lane, maintains the state of each context on the flash lane, provides (e.g., via the context cache) the minimum amount of temporary on-chip storage of contexts needed to execute full transactions, maintains the buffer pointer of each context that is in the process of being executed, and provides agency for each context by determining the next state of the context using the context state machine (CSM) 222. Minimal context information may be maintained in the context table (CT) 220. The context table 220 generally provides a priority queue of contexts currently being executed. The context queue controller (CQC) 226 may be configured to remove completed contexts from the context table 220 and compress the context table 220 to eliminate gaps.

Referring to FIG. 5, a diagram is shown illustrating submodules of the die management module 206 of FIG. 3. In one example, the block 206 may comprise, a die state machine 230, a die service arbiter 232, and a die management table 234.

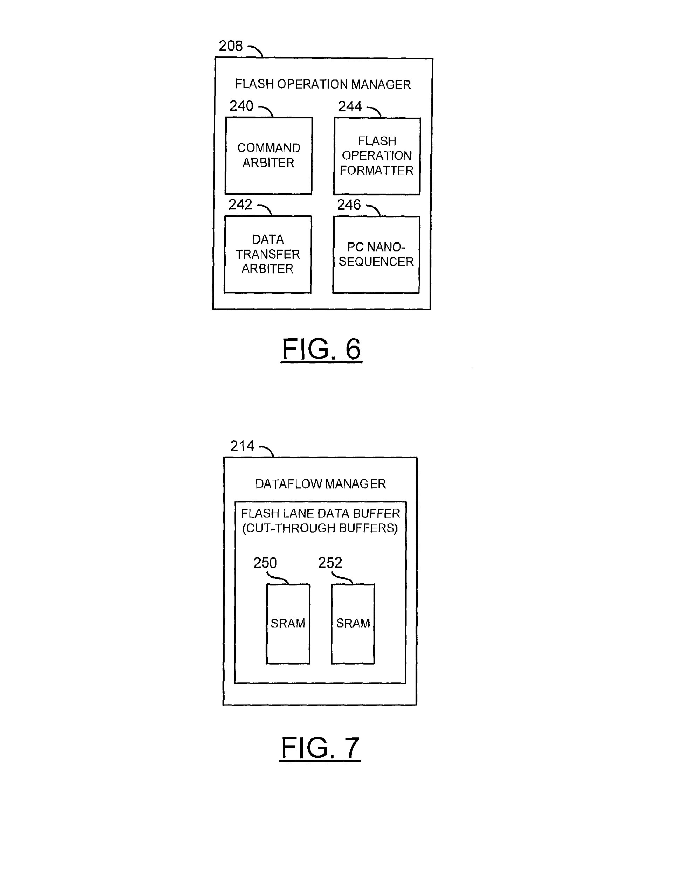

Referring to FIG. 6, a diagram is shown illustrating submodules of the flash operation manager (FOM) 208 of FIG. 3. In one example, the block 208 may be divided into four submodules, a command arbiter (CA) 240, a data transfer arbiter (DTA) 242, a flash operation formatter (FOF) 244, and a nano-sequencer 246. The command arbiter 240 generally scans the context table for the commands to apply, and then communicates with the flash operation formatter (FOF) 244 to send the signals to the flash buffer controller (FBC). Once all of the "command" portions have been run, and the flash is ready for a "data phase", the data transfer arbiter 242 initiates a transfer between the FBC and the dataflow manager (DM) 214. Finally, the nano-sequencer 246 interprets special "soft contexts" to apply any command sequence that a flash may require, even if the command sequence is not natively supported.

Referring to FIG. 7, a diagram is shown illustrating submodules of the dataflow manager 214 of FIG. 3. The dataflow manager 214 generally provides flash lane data buffer memory resources. In one example, the flash lane data buffer memory resources may comprise cut-through buffers 250 and 252. In one example, the cut-through buffers 250 and 252 may be implemented with a size that is programmable. For example, the size of the buffers 250 and 252 may be adjusted to match bandwidth specifications. In one example, the buffers 250 and 252 may comprise static random access memory (SRAM). However, other types of memory maybe implemented accordingly to meet the design criteria of a particular implementation. In general, two cut-through buffers are implemented per flash lane.

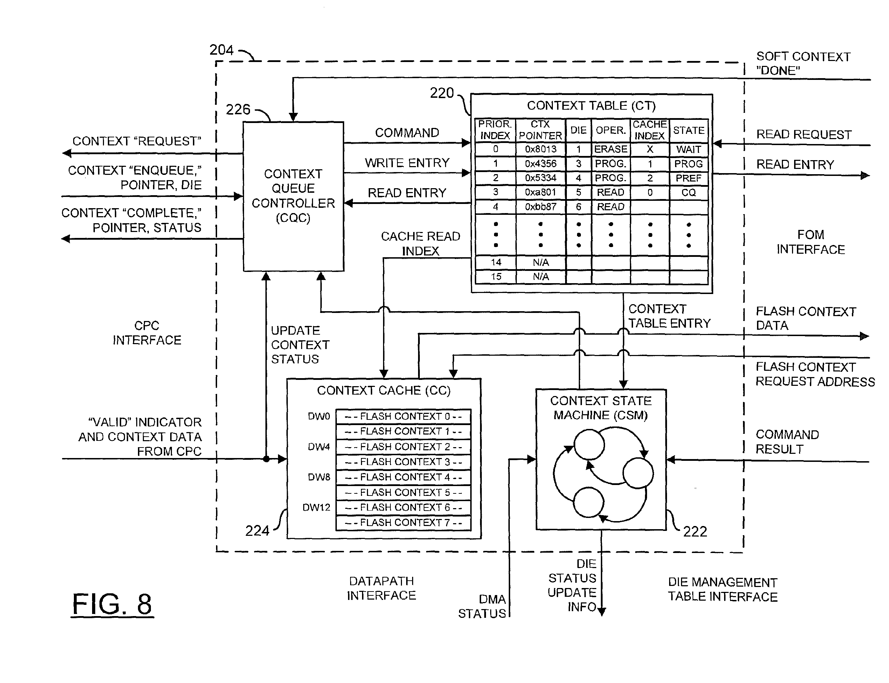

Referring to FIG. 8, a diagram is shown illustrating an example implementation of the context manager (CM) 204 of FIG. 3. The context manager (CM) 204 is generally responsible for managing the contexts that are actively being processed by the respective flash lane controller (FLC). The CM 204 generally performs the "bookkeeping" of active contexts. As stated previously, contexts are data structures that provide all the information used by the flash media controller (FMC) 102 to execute flash transactions and DMAs to the system buffer. The CM 204 manages the contexts at the level of the FLC and thus is primarily concerned with the context management related to the flash transaction. The CM 204 maintains the information used by the flash operation manager (FOM) to perform commands and data transfers to the flash dies on the flash lane.

The CM 204 is generally configured to (i) stage and execute phases of operation on the respective flash lane controller, (ii) maintain priority ordering of all active contexts on the respective flash lane, (iii) maintain the state of each context on the respective flash lane, (iv) provide the minimum amount (or minimize the amount) of temporary on-chip storage (e.g., via the context cache 224) of contexts used to execute full transactions, (v) maintain the buffer pointer of each context that is in the process of being executed, (vi) provide agency for each context by determining the next state of the context using the context state machine (CSM) 222, and (vii) maintain minimal context information in a priority queue of contexts currently being executed (e.g., the context table 220). The context queue controller 226 is generally configured to remove completed contexts from the context table 220 and compress the context table 224 to eliminate gaps.

The context queue controller (CQC) 226 is the logic block that performs modifications on the context table (CT) 220. The CT 220 may be implemented, in one example, as a block of registers that is organized into one entry per enqueued context. The CQC 226 is the block that performs the operations on the table, which is organized as a priority queue. The CQC 226 generally initiates and executes context processes and is responsible for executing the processes on the context table. The main processes generally include Append, Wait, Modify, Dispose, and Compress. The processes are staged and executed by the CQC 226.

The append phase is the phase in which new contexts are fetched by the FMC, and entries for those contexts are added to the context table 220. The CQC 226 inspects the contents of the flash context and the context information presented by the CPC 202 and appends and creates an entry based on the contents and context information. In one example, the context table entry may comprise a bit (or flag) indicating whether a context table entry is active, a value representing the context state, a value representing the context cache index, a value presenting the flash operation, a value representing the flash die, a context pointer, a bit (or flag) indicating whether to disable data transfer and a value representing a plane address. New entries generally begin with the "active" bit set (e.g., a logic '1') and the "context state" set to a value "QUEUED." If the flash operation is illegal, the initial state may be set to a value "ILLEGAL," and the context table entry may be removed during the disposal phase. The other fields are generally determined by the context and the information provided by the CQC 226. New entries are generally appended to the tail of a compressed context table 220. Thus, the CQC 226 is generally aware of the depth of the context table 220.

The CQC 226 generally exits the "append" phase when the CQC 226 is no longer waiting for outstanding data transfers to complete and the CQC 226 has attempted at least one append operation during the given flash operation cycle. The CQC 226 may also leave the "append" phase when there is no longer any space available in the context table 220 or the context cache 224.

The context manager 204 may or may not be forced to wait between full flash operation cycles. The context manager 204 generally has the ability to enforce a minimum flash operation period (e.g., via a flash operation period register). Such a minimum period is desirable for cases where, for example, the flash lane is largely idle except for polling after PROGRAM or ERASE commands. In such instances, the context phases take a very short time to execute, as there are no appends or disposals. Thus, there would be a tendency for the lane to exist in a state where the lane is continuously polling flash die that are busy, thereby consuming power on the flash interface when that power consumption is not warranted. The CQC 226 generally remains in the wait phase until a predetermined time has expired (e.g., a time may be specified in a "flash operation timer" register). When the predetermined time has expired, the CQC 226 may enter the "modify" phase.

The next phase initiated by the CQC is generally the "modify" phase. In the modify phase, the context table 220 is modified based on flash operations performed by the flash operation manager (FOM) and also by results from datapath transfers. The updates are generally related to the state of the context and are thus generally initiated by the context state machine (CSM) 222. When a state update occurs, the CSM 222 sends the updated state and context table index to the CQC 226. The CQC 226 then updates the entry in the context table 220. The modify phase ends when the FOM is done with its cycle of flash interface processes. The FOM may inform the context manager 204 that the flash interface processes are done by asserting a signal (e.g., FOM_CM_FLASH_PROG_CMPLT). Once the modify phase has completed, the CQC 226 may perform the disposal, compression, and appending of contexts on the context table 220. During this time, the context table 220 is inaccessible to the FOM. The CQC 226 may enforce the context table 220 being inaccessible to the FOM by deasserting a signal (e.g., CM_FOM_CT_VALID) indicating to the FOM that the context table read entry and the context cache read data are valid during the particular clock cycle.

When the modify phase has completed, the CPC 202 initiates the "disposal" action. The disposal action puts the CQC 226 into a mode where the CQC 226 searches the context table 220 looking for entries that have completed execution. The CQC 226 bases the decisions of whether entries have completed execution on the states of the contexts. When the contexts are in a "completed" state, the context may be disposed of by the CQC 226. In one example, a context may be in a state in which the CQC 226 is awaiting notification from the datapath as to the completion status of the context. For example, in the case of a READ operation, the context may be in the DATA_TRANSFER_DONE state and awaiting the result of the ECC check. In this case, the CQC 226 may temporarily suspend the disposal process and wait for the status to be returned from the datapath. During this time, the CQC 226 may allow "appends" to occur. Once the awaited status is returned, however, the context may be disposed of by the CQC 226, and the consumed context record may be forwarded to the CPC 202 (and ultimately to the consumed context manager (CCM) 164).

When the CQC 226 has disposed of a context, the CQC 226 clears the "active" bit for the corresponding entry in the context table 220. The process continues until the CQC 226 has reviewed every context in the context table 220. When the CQC 226 reaches the end of the active contexts in the context table 220, the disposal phase is completed.

Contexts that have been disposed of by the CQC 226 have the "active" bits in the respective table entries cleared. Without a mechanism to shift the table up to fill in the holes, the active entries would become disbursed (or fragmented) in the context table 220. Disbursed contexts would make the context table difficult to scan and make the "append" phase more complicated. To ensure that the context table 220 maintains its character as a priority queue, the context table 220 may be compressed. In the compression process, when the CQC 226 disposes of a context, the CQC 226 immediately shifts all the entries after the freed entry up by one position. When the process is complete, all of the active entries are at the front of the list in priority order and all of the "holes" have been removed. As is the case with other actions, the CQC 226 asserts a "done" semaphore (or bit) when the compression process is finished. At the end of the last compress phase, the CQC 226 may start the append phase.

The CQC 226 is generally aware of the processor control mode. In the processor control mode, the entire CM 204 suspends standard operation and proceeds in a mode where the operation of the FLC is essentially driven by "soft contexts" that are executed by the nanosequencer 246 inside the flash operation manager 208. The soft contexts are a different size from the standard flash context. In one example, soft contexts may comprise a full fifteen 32-bit double-words, whereas "flash contexts," the portion of the full media context executed by the FLC, generally comprise just four 32-bit double-words.

The processor control mode (PCM) generally begins when a context whose "flash operation" field is set to PROCESSOR_CONTROL_MODE appears at the top of the context queue. In general, there should be no active entries behind the PCM context in the context table 220, as the CQC 226 should suspend retrieval of standard contexts once the CQC 226 enqueues a PCM context. When the PCM begins, the CQC 226 may notify the CPC 202 via a signal (e.g., CM_CPC_PROC_CNTL_MODE). In response to the notification, the CPC 202 may fetch the "soft context" found at the location given in the PCM context. From the standpoint of what is presented to the FOM, the FOM generally has no knowledge of the existence of the PCM context in the context table 220 while the PCM context is behind other active entries in the context table 220. The PCM context entry in the context table 220 presents its "active" bit to the FOM as 0 until the CM 204 is ready for the FOM to begin executing the soft context.

When the FOM begins reading the soft context, the CQC 226 snoops the operations as the operations are presented to the FOM 208 by the context cache 224, where the soft contexts are stored. When an operation involves a DMA context (e.g., Prefetch Data, Set Read Data Buffer, or Dispose of Context Pointer), the CQC 226 co-opts the now-unused storage in the context table 220 and places the pointers in the context table for tracking. When those DMA contexts complete, the FOM 208 notifies the context manager 204, which then disposes of the contexts in the standard fashion.

While snooping, the CQC 226 also looks for "Fetch Next Soft Context" operations. When the CQC 226 finds one, the CQC 226 asserts a signal (e.g., CM_CQC_PCM_NEXT_CONTEXT) to the CPC 202, which fetches the next soft context. When the FOM 208 informs the CM 204 that the soft context execution is complete, the FOM 208 informs the CM 204 on the FOM/CM command interface. The CQC 226 then deasserts a signal (e.g., CM_CPC_PROC_CNTL_MODE) to the CPC, and standard operation continues. In one example, the signal CM_CPC_PROC_CNTL_MODE may be asserted as a level to indicate that the CM 204 has entered the processor control mode and is now ready to receive soft contexts.

Another important function of the CQC 226 is to monitor timeout situations. In one example, the CQC 226 may contain a counter configured to count the number of system clock (SYS_CLK) cycles that the same context table entry has resided at the top (e.g., at entry 0) of the context table 220. If the count value reaches the value of a programmable "timeout" counter, the entry at the top of the context table 220 may be considered to have timed out. When an entry is considered to have timed out, the entry may be removed from the context table 220, and the context pointer returned to the context process coordinator (CPC) 202 on the consumed context interface.

The return status for the context is one of two possible "timeout" statuses. In the first case, the timeout could potentially be due to a situation where another die on the flash lane is busy and is driving down the R/B line. In this case, the status indicates that the timeout could be due to a timeout on another die. In the second case, the die for the context is known to be the culprit. Here, a different status may be returned indicating that the die is the culprit.

The context table 220 is essentially the storage medium of the entries. The depth of the context table is parameterizable. For example, in the case of a chip that can support 16 die per lane, sixteen entries may be implemented. If more than one operation may be managed per die, increasing the depth may be advantageous. The context table 220 has minimal function. Most of the more involved processing on the context table 220 is performed by the CQC 226. However, the context table 220 may be implemented with multiple read interfaces and multiplexing logic for each of the read interfaces. In one example, the context table 220 may be implemented with an interface to the FOM 208 and an interface to the context state machine (CSM) 222 for read accessibility. The context table 220 also may have a read interface to the CQC 226. The context table 220 may be accessed by the processor, as well.

The context table 220 also has the "shift" capability that is used for the compression phase of the table. Aside from that, the CQC 226 may update the context table 220 using a simple write interface. In one example, the context table 220 may be implemented in flip-flops. When the context table 220 is implemented in flip-flops, there is no arbitration required for read access. If the context table 220 increases in size beyond about 1000 flip-flops, the context table 220 may be implemented in a register file or an SRAM, but additional management and access arbitration should also be implemented.

The context cache 224 is another context data storage element similar to the context table 220. The context cache 224 generally contains a parameterizable number of entries. In one example, the number of entries may be eight. However, other numbers of entries may be implemented to meet the design criteria of a particular implementation. For example, the number of entries may be set to one or two more than is actually needed for fully-pipelined operation. The number should generally be set large enough to allow enough space for full "soft contexts" in the processor control mode. As mentioned above, a full context may comprise fifteen 32-bit double-words. A subset of the full media context is referred to as the "flash context." The flash context is generally the first four double-words (or dwords) of the full media context. The four dwords of the flash context generally contain all the information used by the FLC to execute the full operation specified by firmware. During standard operation (e.g., when the FLC is not in the processor control mode), only the first two dwords of the flash context are stored in the context cache 224. The remainder of the flash context is generally stored in the context table 220.

The context cache 224 generally maintains status on each entry. In one example, the status may comprise a bit indicating whether the entry is FREE or USED. In one example, eight such bits may be implemented in the context cache 224. When a flash context is written to a location in the context cache 224, the status of the location becomes USED. When the CQC 226 receives information on a state change that allows that location to clear, the state of the location returns to FREE. During standard operation, the context cache 224 notifies the CQC 226 that the context cache 224 has space for a free entry based on the status bits. If there is a free location, the CQC 226 is free to request a context from the CPC 202. When the CPC 202 has fetched a new flash context, the CPC 202 presents the flash context to the context cache 224 as a burst of 32-bit double-words of data. A signal (e.g., CPC_CM_ENQ_CTX_VALID) may be asserted when the data is valid. The context cache 224 writes the data into the free location. The context cache 224 expects that the CPC 202 will only write one flash context.

In the processor control mode, which is entered when the entry at the top of the context table 220 is indicated as a PROCESSOR_CONTROL_MODE operation, the context cache 224 should be completely free. In the processor control mode, the context cache 224 should expect to receive a soft context from the CPC 202. The context cache 224 may also expect the soft context to include 15 dwords. Essentially, the context cache 224 acts as a slave, accepting any data presented by the CPC 202. It is the responsibility of the CPC 202 to write the proper amount of data to the context cache 224. The context cache 224 is accessible by the FOM 208, which uses the full flash context information when performing the actual command on the flash unit. The FOM 208 provides an address to a 32-bit double-word, and the context cache 224 responds with the requested double-word on the following clock cycle. During the processor control mode, read responses from the context cache 224 are snooped by the context queue controller (CQC) 226, which may perform actions based on the contents of the operations. The context cache 224 may also be accessible by the processor interface, as is the context table 220.

The FOM 208 reads the entry from the context table 220 and executes the operation. The FOM 208 updates the context state machine (CSM) 222 after executing the operation. The CSM 222 stores the state in the particular entry of context table 220. The FOM 208 then proceeds with the next entry to execute and so on. After reaching the end of the context, the FOM 208 rolls over and performs the entry once again to check the next part of the execution. The process of executing multiple entries in the context table 220 generally provides pipeline execution of the commands on the flash interface. The pipeline execution of the commands on the flash interface generally provides effective utilization of the flash interface. By executing multiple entries part by part and restoring the state in the context table 220, the FOM 208 provides more effective utilization of the flash interface than conventional techniques.

Referring to FIG. 9, a flow diagram is shown illustrating an example process 300 by which the FOM 208 may execute multiple entries part by part and restore the state in the context table 220. In one example, the process (or method) 300 may comprise a step (or state) 302, a step (or state) 304, a step (or state) 306, a step (or state) 308, a step (or state) 310, a step (or state) 312, and a step (or state) 314. In the step 302, the FOM 208 may check whether there are a predetermined number (e.g., N) of entries in the context table 220. The predetermined number of entries N may be configurable (e.g., a value in a register, etc.). In one example, the number N may be set as four (4). In another example, the number N may be set as ten (10). In the example where N is set to the value of 10, the process 300 may remain in the state 302 until there are 10 entries in the context table 220. When there are 10 entries in the context table 220, the process 300 may proceed to the step 304. In the step 304, the FOM 208 reads entry 1 of the context table 220 and executes part of the command. The process 300 then moves to the step 306. In the step 306, the FOM 208 updates this information to the CSM 222, and the process 300 moves to the step 308. In the step 308, the CSM 222 updates this information to entry 1 of the context table 220, and the process 300 moves to the step 310. In the step 310, the FOM 208 reads the next entry (e.g., entry 2) of the context table 220 and executes part of the command. The process 300 then moves to the step 312. In the step 312, the process repeats steps 306 through 310 until entry 10 of the context table 220 is reached. When part of each of the 10 entries have been executed, the process 300 may move to the step 314. In the step 314, the process 300 may check whether all ten entries have been completed. If entries remain to be completed, the process 300 returns to the step 304, where the FOM 208 rolls back, checks each entry again, and executes any remaining part of the commands until all of the predetermined number of entries have been completed.

The CSM 222 is generally configured to determine the execution state of each context in the context table 220 based on the current state of the entry and either the operation being performed by the FOM 208 or the status of a datapath operation. In the modify phase, the CSM 222 is called by the CQC 226 every time the FOM 208 applies a command or returns a result. The contents of the FOM command notification interface and the FOM context table read interface generally provide all the information needed for the CSM 222 to determine the next state.

In the dispose phase, the CSM 222 is called by the CQC 226 when the CQC 226 scans the context table 220 and encounters a context table entry that is in a state in which the context table entry is awaiting action (e.g., a TRANSFER_DATA state or a PREFETCH_DATA state). When the TRANSFER_DATA state or the PREFETCH_DATA state is encountered, the CQC 226 awaits information from the datapath (e.g., either the DM, the DDM, or the DTP) regarding the status of the data transfer. Either way, the CSM 222 is generally called to determine the next state for the context table entry in question. The CSM 222 is also responsible for notifying the die management module 206 when a context table entry moves to a completion state (e.g., COMPLETED or COMPLETED WITH ERROR).

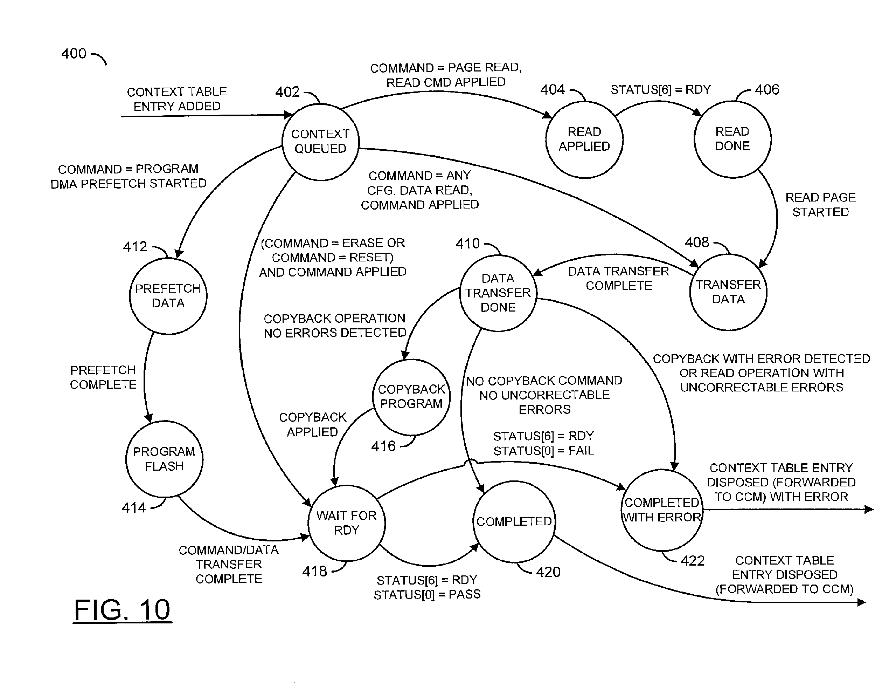

Referring to FIG. 10, a diagram is shown illustrating an example implementation of a context state machine (CSM) 400. In one example, the CSM 400 may be used to implement the CSM 222 of FIG. 8. In one example, the CSM 400 may comprise a state 402, a state 404, a state 406, a state 408, a state 410, a state 412, a state 414, a state 416, a state 418, a state 420, and a state 422. The state 402 may comprise a context queued state. The state 404 may comprise a read applied state. The state 404 may comprise a read done state. The state 404 may comprise a transfer data state. The state 404 may comprise a data transfer done state. The state 404 may comprise a prefetch data state. The state 404 may comprise a program flash state. The state 404 may comprise a copyback program state. The state 404 may comprise a wait for ready state. The state 404 may comprise a completed state. The state 404 may comprise a completed with error state. Once the append phase has been completed, and the context manager (CM)204 has waited an appropriate amount of time (e.g., either for the completion of all outstanding data transfers or for a minimum "flash operation period" time to elapse), the context table 220 is ready to be used by the flash operation manager (FOM) 208 to select commands and data transfers to apply to the flash lane. When those commands are applied, the FOM 208 notifies the CM 204, and the CM 204 modifies the affected entry appropriately. Because commands are executed to the flash serially, the updates to the context states occur serially; thus, separate, concurrent hardware state machine entities are not required for context table entry. The entries may share the single instance of the CSM 400. Only state information needs to be stored, and state transitions may be determined using current state information and command/status information.

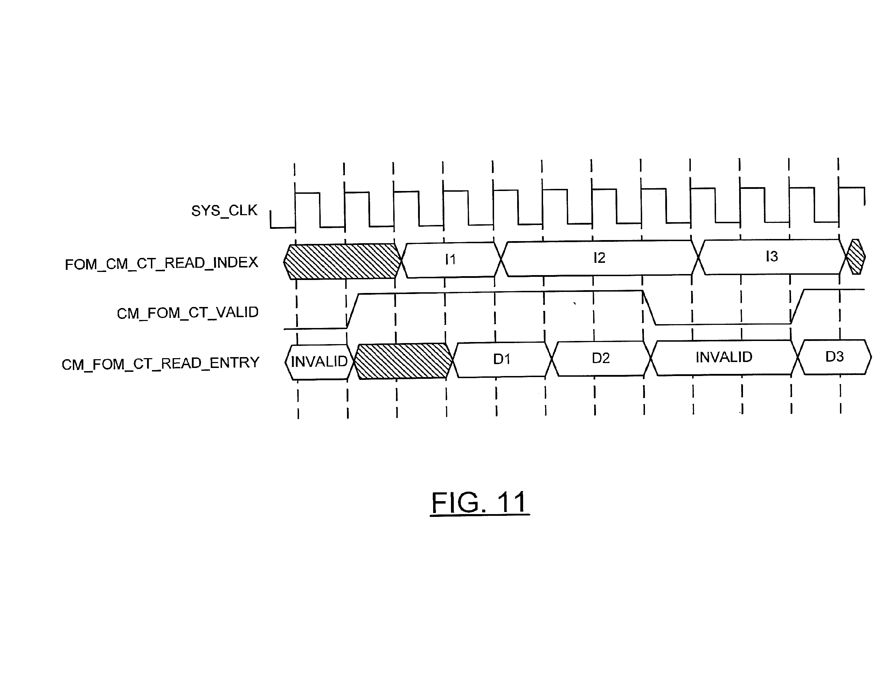

Referring to FIG. 11, a timing diagram illustrating an example read timing for the flash operation manager (FOM) context table access interface of FIG. 8. A similar timing may be implemented on the context cache interface to the flash operation manager (FOM).

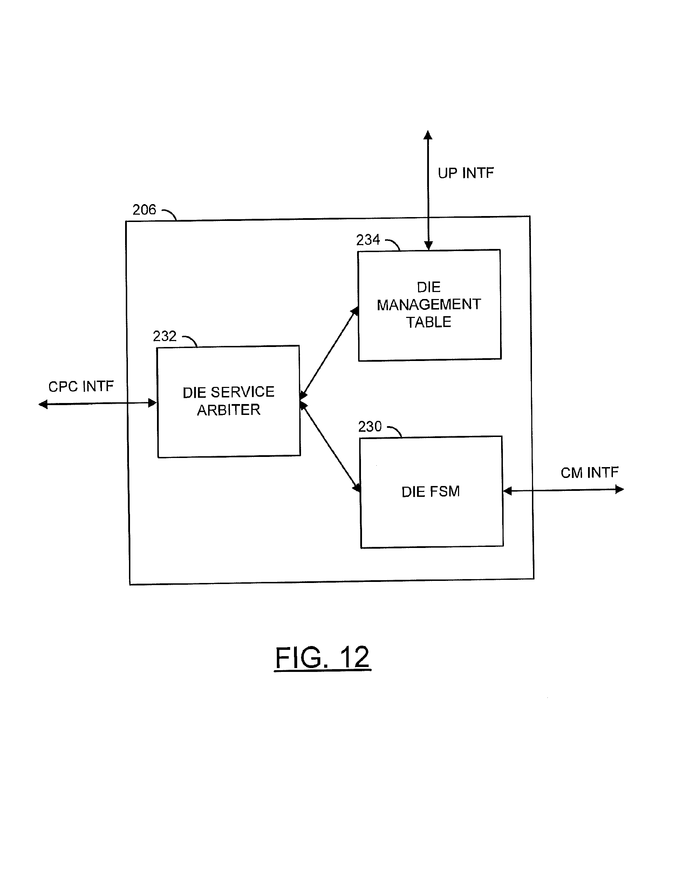

Referring to FIG. 12, is a diagram illustrating an example implementation of the die management module of FIGS. 3 and 5. The die management module (DMM) 206 is generally responsible for maintaining die-based information used for operation of the flash lane controller (FLC). In one example, the DMM 206 may comprise a block (or circuit) 230, a block (or circuit) 232 and a block (or circuit) 234. The block 230 may implement a die state machine (DIE FSM). The block 232 may implement a die service arbiter. The block 234 may implement a die management table. The DMM 206 is generally configured to manage per-die information in the die management table 234, arbitrate among the dies for access to be queued to the context table 220, update die status using the die state machine 230, and perform/monitor multi-die operation. The DMM 206 is generally responsible for flash commands including, but not limited to, READ, COPYBACK READ/COPYBACK WRITE, BLOCK ERASE, and PAGE PROGRAM. The DMM 206 may also be responsible for target level commands including, but not limited to, READ ID, READ PARAMETER PAGE, GET FEATURES, SET FEATURES, SYNCHRONOUS RESET, and RESET.

In one example, the die management module (DMM) 206 may have an interface (e.g., CPC INTF) to the context process coordinator (CPC) 202, an interface (e.g., CM INTF) to the context manager (CM) 204, and a processor interface (e.g., UP INTF). The CPC and CM interfaces may include, but is not limited to signals for (i) CPC requests context pointer, (ii) indicating the DMM DSA has finished arbitration, (iii) indicating whether the context pointer is valid or not, (iv) indicating the context pointer of a winning die, (v) indicating the number of the winning die, (vi) updating the die management table 234 for the next pointer and command type of the winning die, and (vii) causing the die management module 206 to update the die management table and set the status of the corresponding die to free. The processor interface may include, but is not limited to signals for (i) register write strobes (e.g., for context next pointer, context end pointer, context fetch enable, etc.), (ii) processor data bus, (iii) context next pointer register value, (iv) context end pointer register value, (v) context fetch enable register value, (vi) die status, and (vi) controlling multi-die operations.

The die management table 234 generally stores per-die information, including context linked-list pointers, status bits, and credits accrued by dies that have been "held off" by the selection of other dies that share their targets. Each die has an entry in the die management table 234 with fields that may, in one example, include Context Next Pointer, Context End Pointer, Context Fetch Enable, Credit Count, and State Vector. The Context Next Pointer is generally the next context pointer in the linked list for the context to be executed. The Context Next Pointer is initially set by the processor, then updated by hardware as contexts are fetched. The Context End Pointer is generally the last pointer in the linked list of the context queue for the die. The Context End Pointer is generally set by the processor. The Context Fetch Enable field is generally used by the processor to enable the automation of fetching and execution of contexts by hardware. The Credit Count field generally contains a value representing the number of credits due the die due to "lock-out" situations where another die on the target is queued up with a read series or some other command that inhibits the die from being selected. The State Vector field generally holds the state of the die from the standpoint of the controller. That is, the State Vector field is not necessarily the RDY/ARDY state of the die, but rather a state vector that contains additional information about the current operation that is needed by the arbitration in the die service arbiter 232 and the context state machine 222 in the context manager 204.

The Context Next Pointer and Context End Pointer are generally used by the processor to set up the linked list of contexts to be executed by the FLC. The Context Next Pointer is updated by the hardware after a context is fetched. When the Next Pointer and End Pointer are equal, the queue is considered by the hardware to be empty for the die. The processor may add to the linked list for a die by simply modifying the Context End Pointer.

The fields of the State Vector may include Target Busy, Command Type, and DieBusy. The Target Busy field generally indicates that the respective die has an operation in progress (or queued) that suspends the operation of multi-die commands, meaning that other dies sharing the target are unable to queue commands. READ and COPYBACK commands are likely to fall into this category. All target level commands generally make the bit set. The Command Type field generally indicates the last operation type applied to the flash. In one example, the allowed values may include NONE, READ, PROGRAM, ERASE, COPYBACK and OTHER. The value OTHER generally refers to target-level operations. The Command Type field is generally updated when the context is fetched. In one example, the DieBusy field may be implemented as a semaphore bit having a first state (e.g., a logic '0') or a second state (e.g., a logic '1'). The DieBusy field generally indicates which stage of processing the die is involved in at present. In one example, the DieBusy field may be implemented with values defined as follows:
0: FREE - the operation has completed, and the die is completely free (e.g., a READ command can be DONE, but the die is not FREE until after the data has been transferred).
1: BUSY.

During the append phase of the context process flow, the die service arbiter (DSA) 232 may be called to select a die which is to have a context selected from its linked list for execution. In one example, the DSA 232 may use a two level arbitration strategy. The first level of arbitration may be based on the credit count field in the die management table 234. For example, the die with the highest credit will win the arbitration. Initially credit count may be set to zero for all dies. The credit count is then incremented by the hardware if the die wins during round-robin stage but inhibited because of multi-die operation restriction. The second level of arbitration may be to use a round-robin approach to determine which die to serve next. The DSA 232 may search through the targets in order, starting with the first die, then recycle through the targets, this time using the second die. If the selected die has a context in its linked list (e.g., Context Next Pointer is not equal to Context End Pointer, and Context Fetch Enable is set to a 1), that context pointer may be sent to the context process controller (CPC) 202.

Similar to the context manager 204, the die management module 206 includes a die state machine (DIE FSM) 230 to manage the states mentioned above for each die. In general, there is one instance of the die state machine 230. The die state machine 230 instance is generally shared by all dies, as only one die at any given point in time is ever undergoing a state change. The die state machine 230 monitors the die status signals from the context manager (CM) 204, and updates the die management table 234 accordingly.

There are times where a die may be ready to accept an operation, but another die that shares the target may be busy with an operation that does not allow multi-die operations. If that happens, the die is "credited" with an operation, and that die will receive priority as soon as the "lock-out" condition is removed by the other die. A target is generally controlled by one chip enable signal (e.g., CE#). A target is generally organized into one or more logical units (LUN, die). For example, when one die is in the process of a read command, no command may be issued to a second die sharing the same chip enable. This restriction stems from the fact that the READY/BUSY state of the first die is indeterminate. Even if one were to read the status of the first die immediately before performing the READ PAGE command to the second die, and the status was BUSY, it could become READY by the time the READ PAGE command was applied to the second die. The reason this is a problem is that, when a die is BUSY, it is not actively "listening" to the command/address bus when CE is enabled. However, when the die is READY, it begins "listening." When the die listens, the die stores the address of the command, even if the command is not destined for the die in question. That address is then used to select the active plane. Thus, when the data is ultimately transferred from the page register of the die, the data could inadvertently be transferred from the page register of the wrong plane. In order to ensure that there are no such issues, no multi-die accesses are permitted when one die is in the midst of a READ PAGE (or a COPYBACK PAGE) transaction.

The following target level commands generally cause the target_busy bit to be set, READ ID, READ PARAMETER PAGE, GET FEATURES, SET FEATURES, SYNCHRONOUS RESET, and RESET. In general, no other command is issued to the target when the target is busy. There is an exception to this rule when the ONFI 2.0 interface is implemented. According to ONFI 2.0, flash commands RESET and SYNCHRONOUS RESET are acceptable while an accessed LUN is busy and acceptable while other LUNs are busy. When the ONFI 2.0 interface is implemented the flash media controller implemented in accordance with an embodiment of the present invention may be programed to allow RESET or SYNCHRONOUS RESET to be issued even if the target is busy. In one example, the DSA 232 may be configured to recognize when two or more dies share a target by inspecting a value of a Number of Dies per Target register. In another example, a multi-die enable bit in a register may be implement for each DMM supported flash command.

In one example, an operation of the die management module may proceed as follows. The firmware loads the "Context Next Pointer" register and the "Context End of Pointer" register into the die management table (DMT) 234 for the die onto which the context(s) are to be executed. Firmware has full access to the die management table 234, initially firmware is responsible for constructing the table for all dies. The firmware allows the operations to begin on that die by setting the "context fetch enable" bit in the DMT 234 for the die. When the die service arbiter (DSA) 232 is selecting dies to serve and sees a die with different next pointers and end pointers and the "context fetch enable" bit set, the die service arbiter (DSA) 232 sends a fetch request with the context pointer to the context process controller (CPC) 202 in the FLC. The CPC 202 in the FLC sends the fetch request and the pointer to the contexts fetch arbiter (CFA) 160. The contexts retrieval port (CRP) 166 retrieves the context and forwards the part of the context needed by the FLC to the CFA 160, which forwards the part to the CPC 202. The CPC 202 notifies the die management module (DMM) 206, which updates the state of the die in the die management table (DMT) 234. The "Context Next Pointer" field in the DMT 234 is updated based on the fetched context. Concurrently, the die state machine (DSA) 230 monitors the context manager 204 for die operation status, and updates the DMT 234 accordingly.

A major submodule of a flash media controller (FMC) in accordance with an embodiment of the present invention is a flash lane controller (FLC). The flash lane controller is essentially a standalone flash lane controller. Multiple instantiations of the FLC are managed by the FMC. On a single flash lane, there may be multiple flash targets and within each flash target there may be multiple logical unit numbers (LUNs). Each of the LUNs is able to execute a flash transaction independently. The flash lane controller is configured to pipeline the flash transactions with help of a die management module (DMM) and a context manager (CM). Due to the nature of pipeline operation, there is need to track and issue pipeline flash commands, which is taken care of by the DMM and the CM. In one embodiment of the present invention, a method used by a die management table and context manager hardware in a flash media controller architecture generally helps to achieve maximum utilization of the flash interface.

The functions represented by the diagrams of FIGS. 1-12 may be implemented using one or more of a conventional general purpose processor, digital computer, microprocessor, microcontroller, RISC (reduced instruction set computer) processor, CISC (complex instruction set computer) processor, SIMD (single instruction multiple data) processor, signal processor, central processing unit (CPU), arithmetic logic unit (ALU), video digital signal processor (VDSP) and/or similar computational machines, programmed according to the teachings of the present specification, as will be apparent to those skilled in the relevant art(s). Appropriate software, firmware, coding, routines, instructions, opcodes, microcode, and/or program modules may readily be prepared by skilled programmers based on the teachings of the present disclosure, as will also be apparent to those skilled in the relevant art(s). The software is generally executed from a medium or several media by one or more of the processors of the machine implementation.

The present invention may also be implemented by the preparation of ASICs (application specific integrated circuits), Platform ASICs, FPGAs (field programmable gate arrays), PLDs (programmable logic devices), CPLDs (complex programmable logic device), sea-of-gates, RFICs (radio frequency integrated circuits), ASSPs (application specific standard products), one or more monolithic integrated circuits, one or more chips or die arranged as flip-chip modules and/or multi-chip modules or by interconnecting an appropriate network of conventional component circuits, as is described herein, modifications of which will be readily apparent to those skilled in the art(s).

The present invention thus may also include a computer product which may be a storage medium or media and/or a transmission medium or media including instructions which may be used to program a machine to perform one or more processes or methods in accordance with the present invention. Execution of instructions contained in the computer product by the machine, along with operations of surrounding circuitry, may transform input data into one or more files on the storage medium and/or one or more output signals representative of a physical object or substance, such as an audio and/or visual depiction. The storage medium may include, but is not limited to, any type of disk including floppy disk, hard drive, magnetic disk, optical disk, CD-ROM, DVD and magneto-optical disks and circuits such as ROMs (read-only memories), RAMs (random access memories), EPROMs (erasable programmable ROMs), EEPROMs (electrically erasable programmable ROMs), UVPROM (ultra-violet erasable programmable ROMs), Flash memory, magnetic cards, optical cards, and/or any type of media suitable for storing electronic instructions.

The elements of the invention may form part or all of one or more devices, units, components, systems, machines and/or apparatuses. The devices may include, but are not limited to, servers, workstations, storage array controllers, storage systems, personal computers, laptop computers, notebook computers, palm computers, personal digital assistants, portable electronic devices, battery powered devices, set-top boxes, encoders, decoders, transcoders, compressors, decompressors, pre-processors, post-processors, transmitters, receivers, transceivers, cipher circuits, cellular telephones, digital cameras, positioning and/or navigation systems, medical equipment, heads-up displays, wireless devices, audio recording, audio storage and/or audio playback devices, video recording, video storage and/or video playback devices, game platforms, peripherals and/or multi-chip modules. Those skilled in the relevant art(s) would understand that the elements of the invention may be implemented in other types of devices to meet the criteria of a particular application.

While the invention has been particularly shown and described with reference to the preferred embodiments thereof, it will be understood by those skilled in the art that various changes in form and details may be made without departing from the scope of the invention.

## Claims

1. An apparatus comprising:
a first circuit configured to maintain die-based information used for operation of a flash lane controller (FLC);
a second circuit configured to manage contexts that are actively being processed by the flash lane controller (FLC); and
a third circuit configured to perform pipeline execution of a plurality of said contexts managed by said second circuit.

2. The apparatus according to claim 1, wherein said first circuit comprises a die management module.

3. The apparatus according to claim 2, wherein said die management module comprises:
a die management table;
a die state machine configured to monitor a context manager of said apparatus for die operation status and update the die management table; and
a die service arbiter configured to select a die which is to have a context selected from a linked list for execution.

4. The apparatus according to claim 1, wherein said second circuit comprises a context manager.

5. The apparatus according to claim 1, wherein said context manager comprises:
a context table storing a priority queue of contexts currently being executed;
a context queue controller configured to remove completed contexts from the context table and compress the context table to eliminate gaps;
a context state machine configured to determine an execution state of each context in the context table; and
a context cache configured to store a portion of each flash context in said context table.

6. The apparatus according to claim 5, wherein said context state machine determines the execution state of each context entry in the context table based on a current state of the context entry and either an operation being performed by a flash operation manager or a status of a datapath operation.

7. The apparatus according to claim 1, wherein said second circuit is primarily concerned with the context management related to flash transactions.

8. The apparatus according to claim 1, wherein said third circuit comprises a flash operation manager (FOM).

9. The apparatus according to claim 8, wherein said second circuit maintains information utilized by said flash operation manager (FOM) to perform said pipeline execution of commands and data transfers to the flash dies on the flash lane.

10. A method of utilizing a flash interface comprising:
maintaining die-based information utilized by a flash lane controller (FLC) in transactions with a plurality of flash devices;
managing contexts that are actively being processed by the flash lane controller (FLC); and
performing pipeline execution of a plurality of said contexts.

11. The method according to claim 10, further comprising:
maintaining a die management table using a die state machine configured to monitor a context manager for die operation status and update the die management table; and
select a die from said plurality of flash devices which is to have a context selected from a linked list for execution.

12. The method according to claim 10, further comprising:
maintaining a context table storing a priority queue of contexts currently being executed;
removing completed contexts from the context table and compressing the context table to eliminate gaps;
determining an execution state of each context in the context table using a context state machine; and
storing a portion of each flash context in said context table in a context cache.

13. The method according to claim 12, wherein determining the execution state of each context entry in the context table is based on a current state of the context entry and either an operation being performed by a flash operation manager or a status of a datapath operation.

14. The method according to claim 10, wherein said contexts are related to flash transactions.

15. The method according to claim 10, further comprising:
maintaining information utilized by a flash operation manager (FOM) to perform pipeline execution of commands and data transfers to the plurality of flash devices on one or more flash lanes.
